# EUROPEAN PATENT SPECIFICATION

(11) **EP 3 754 805 B1**
(45) Date of publication and mention of the grant of the patent: **14.12.2022**
(21) Application number: 19181316.1
(22) Date of filing: 19.06.2019
(51) Int. Cl.: H02H 7/26, H02H 3/04, G01R 31/08

(54) **METHOD, APPARATUS AND COMPUTER PROGRAM FOR LOCATING A FAULT IN A POWER DISTRIBUTION GRID**
VERFAHREN, VORRICHTUNG UND COMPUTERPROGRAMM ZUR LOKALISIERUNG EINES FEHLERS IN EINEM STROMVERTEILUNGSNETZ
PROCÉDÉ, APPAREIL ET PROGRAMME INFORMATIQUE PERMETTANT DE LOCALISER UN DÉFAUT DANS UN RÉSEAU DE DISTRIBUTION D'ÉNERGIE

(43) Date of publication of application: 23.12.2020
(73) Proprietor: Siemens Aktiengesellschaft, 80333 München (DE)
(72) Inventor: Ferreira, Lucas Roberto, 82515-396 Curitiba/PR (BR); Fonseca, Alexandre Gomes, 80540-130 Curitiba/PR (BR); Yamasaki Junior, Marcos, 81510-360 Curitiba/PR (BR); Haas, Paulo, 80050-270 Curitiba/PR (BR); Antunes De Souza Junior, Paulo Roberto, 13213-000 Jundiai Sao Paulo (BR); Schrödel, Oliver, 91220 Schnaittach (DE); Borisuk, Leonid, 90489 Nürnberg (DE); Vaz Sigoli, Mariana, 90459 Nürnberg (DE)

(56) References cited:
- KR-A- 20110 026 719
- US-A1- 2011 031 977
- US-B1- 6 249 230
- US-B1- 6 477 475

## Description

### Field of Invention

The present invention relates to the field of electric power distribution systems, in particular to a method of locating a fault in a power distribution grid, the power distribution grid comprising at least one power source and a plurality of grid segments interconnected by switching devices, each switching device having an associated protective device capable of detecting a fault current and of transmitting a corresponding fault indication. The present invention further relates to a corresponding apparatus for locating a fault in a power distribution grid.

### Art Background

When a fault occurs in a power distribution grid, it is important to locate the fault as fast and precise as possible in order to handle the fault with a minimum of disturbance experienced by customers.

Classical operation procedures require system operators to manually examine fault indications received from sensors and other fault detection equipment within the power distribution grid. Accordingly, this process relies heavily on the operator's experience and knowledge of the grid topology. In cases where the fault indications do not provide the operator with sufficient information to locate the fault, some additional operational processes may have to take place, such as deenergizing selected segments of the grid until the faulty segment is located.

This manual fault location process suffers from a number of drawbacks. One drawback is the limited reliability of fault indications received from sensors and detection equipment within the grid. The sensors are usually built to be cheap, and as they suffer with weather conditions and temperature, their ability to provide reliable information may be affected during their lifespan. Furthermore, various errors may occur during setup of the sensors. For example, some directional fault indications may be inverted due to wrong cabling setup.

Another drawback is the impact of signal transmission delays. As different fault indications may be transmitted to the control center by different communication channels (4G, radio frequency mesh, etc.) with different latencies and availability ratios, the fault indications may arrive at the control center at different times, or even be lost on their way. This interferes directly with the operator's analysis, as it may be necessary to infer the location of missing fault indications to establish a location hypothesis.

A further and very important drawback is the divided attention of the operators during fault events. In overhead distribution grids, for example, severe storms may affect several areas at the same time, requiring operators to take care of several events at once. The assignments of a distribution operator can be really diverse, from focusing on the supervisory system and switching maneuvers to redirecting maintenance crew and calling operators in other control centers.

From US 2011/0031977 A1 and US 6,477,475 B1, methods for automatically detecting the location of a fault in power distribution systems are known.

Accordingly, there may be a need for an improved, in particular automated, way of locating faults in power distribution grids, which at least overcomes or significantly reduces the impact of the above-mentioned drawbacks, and in particular is able to handle inconsistent fault indications.

### Summary of the Invention

This need may be met by the subject matter according to the independent claims. Advantageous embodiments of the present invention are described by the dependent claims.

According to a first aspect of the invention there is provided a method of locating a fault in a power distribution grid, the power distribution grid comprising at least one power source and a plurality of grid segments interconnected by switching devices, each switching device having an associated protective device capable of detecting a fault current and of transmitting a corresponding fault indication. The method comprises (a) receiving a set of fault indications from a corresponding set of protective devices, (b) determining a fault path based on the set of fault indications, the fault path comprising a set of grid segments and corresponding switching devices that form a path for the fault current flowing from the power source towards the fault, (c) selecting the next grid segment in front of the fault path as the location of the fault, and (d) isolating the fault by operating corresponding switching devices.

This aspect of the invention is based on the idea that the received fault indications are used to determine a fault path within the grid, the fault path being a set of grid segments and switching devices through which a current associated with the fault flows from the power source towards the fault. The location of the fault is then selected as the next grid segment in front of the fault path, i.e. the grid segment connected to the switching device of the fault path that is farthest from the power source (in a downstream direction from the power source towards the fault). The grid segment thus selected as being the fault location is then isolated from the grid by opening corresponding switches, such that the remaining power distribution grid may continue operating.

In the present context, the term "fault indication" may in particular denote (i) a single value (non-directional fault indication) indicating that a fault current is detected within the corresponding protective device, or (ii) a set of values (directional fault indication) indicating that a fault current is detected and also a direction of the detected fault current.

According to the invention, the method further comprises (a) identifying inconsistent fault indications in the fault path, and if the number of inconsistent fault indications is below or equal to a predetermined threshold value, (b) isolating the fault by disconnecting all segments connected to the end of the fault path.

In the present context, the term "inconsistent fault indication" denotes a fault indication that is inconsistent with other fault indications along the fault path in the sense that it leads to a different result than the other fault indications or that it would have to have a different value when considering the other fault indications.

In this way, any inconsistent fault indications within the fault path are identified and as long as the number of identified inconsistent fault indications does not exceed a predetermined threshold value, the fault is isolated by disconnecting the grid segments that are connected to the downstream end of the fault path.

In other words, as long as the number of inconsistent fault locations does not exceed the threshold value, the fault path is considered to be valid in the sense that the fault is located directly in front of the fault path.

The predetermined threshold value may in particular be selected in dependency of characteristics of the particular power distribution grid, such as grid topology. Furthermore, the predetermined threshold value may be determined using a grid simulator to simulate various faults and evaluating the number of inconsistent fault indications that leads to acceptable robustness in the fault localization.

According to an exemplary embodiment of the invention, the method further comprises: if the number of inconsistent fault indications is below or equal to the predetermined threshold value and the fault indication corresponding to the end of the fault path is an inconsistent fault indication, selecting the grid segment at the end of the fault path as the fault location.

In other words, in the case where the number of inconsistent fault indications does not exceed the threshold value and the (downstream) end of the fault path has an inconsistent fault indication assigned to it, the last (downstream) grid segment of the fault path is selected as the fault location (instead of the previously selected grid segment in front of the fault path).

Thereby, the uncertainty resulting from the inconsistent fault indication at the end of fault path is taken into account.

According to a further embodiment of the invention, the method further comprises: if the number of inconsistent fault indications is below or equal to the predetermined threshold value, disregarding inconsistent fault indications that do not correspond to the end of the fault path.

In other words, as long as the threshold value is not exceeded, all inconsistent fault indications within the fault path (i.e. not at the end of the fault path) are disregarded. Thus, it is assumed that these inconsistent fault indications are caused by an error, e.g. a hardware error or a transmission error and that the fault path is nevertheless valid.

According to a further embodiment of the invention, the set of fault indications comprises at least one directional fault indication pointing to a particular grid segment connected to the corresponding protective device as the direction towards the location of the fault.

In other words, at least one of the fault indications indicates not just the presence of a fault current but also the direction of the fault current.

According to a further embodiment of the invention, the step of identifying inconsistent fault indications in the fault path comprises identifying directional fault indications which indicate differing or opposite directions towards the location of the fault.

As an example, a directional fault indication from a protective device arranged between two neighboring grid segment may be determined to be an inconsistent fault indication if it indicates one direction (e.g. upstream) of the fault current while the protective devices at the opposite ends of both grid segments provide directional fault indications indicating the opposite direction (e.g. downstream) of the fault current.

According to a further embodiment of the invention, the method further comprises: if the number of inconsistent fault indications is above the predetermined threshold value, outputting an error message indicating that the location of the fault cannot be determined and/or operating a main switch to disconnect the power distribution grid from the power source.

In other words, when the number of inconsistent fault indications exceeds the threshold value, the fault path is considered to be too unreliable to determine the fault location and therefore an error message is output in order to notify a grid operator and/or a main switch is automatically operated to disconnect the power distribution grid from the power source.

According to a further embodiment of the invention, the set of fault indications is received within a predetermined period of time after receiving a first fault indication.

The predetermined period of time is selected to be sufficiently long to assure that subsequent (possibly delayed) fault indications relating to the same fault are received before continuing to determine the fault path. On the other hand, the predetermined period of time is selected to be short enough to avoid that the fault causes severe damage.

According to a further embodiment of the invention, the power distribution grid is a compensated power distribution grid, i.e. a power distribution grid comprising at least one Peterson coil (or arc suppression coil).

According to a further embodiment of the invention, the fault is an earth fault, i.e. a fault caused by a connection between a power cable of the grid and ground.

According to a further embodiment of the invention, the protective devices comprise fault passage indicators, and/or field processors, and/or over-current protective devices.

According to a second aspect of the invention there is provided an apparatus for locating a fault in a power distribution grid, the power distribution grid comprising at least one power source and a plurality of grid segments interconnected by switching devices, each switching device having an associated protective device being capable of detecting a fault current and of transmitting a corresponding fault indication. The apparatus comprises a processing unit configured to perform the method according to the first aspect or any of the embodiments described above.

This aspect of the invention is based on essentially the same idea as the first aspect.

According to a further embodiment of the invention, the apparatus is comprised by a protective device, a central device or a cloud computing platform.

In other words, the apparatus may be located within one (or more) protective device(s) within the power distribution grid, within a central device (such as a grid controller) or in a cloud computer platform at a remote location.

According to a third aspect of the invention there is provided a computer program comprising computer executable instructions which, when executed by a computer processing unit, are configured to cause the computer to perform the method according to the first aspect or any of the embodiments described above.

The methods, apparatuses and computer programs described above may in particular be used in the framework of so-called self-healing applications for power distribution grids, i.e. control systems that supervise electrical measurements and act automatically over switching equipment in order to isolate faults and restore power supply to non-affected customers as quickly as possible. It should be noted that the computer program of the apparatus is not hard coded - the sequences are not fixed in code or generated for some specific grid structure. Based on the grid layout / segments the algorithm calculates the sequence for the switching devices. It would be also possible to hard code the different sequences in the computer program. However, with the present invention the switching sequence is dynamically created based on the grid layout and directional indications.

It is noted that embodiments of the invention have been described with reference to different subject matters. In particular, some embodiments have been described with reference to method type claims whereas other embodiments have been described with reference to apparatus type claims. However, a person skilled in the art will gather from the above and the following description that, unless otherwise indicated, in addition to any combination of features belonging to one type of subject matter also any combination of features relating to different subject matters, in particular to combinations of features of the method type claims and features of the apparatus type claims, is part of the disclosure of this document.

The aspects defined above and further aspects of the present invention are apparent from the examples of embodiments to be described hereinafter and are explained with reference to the examples of embodiments. The invention will be described in more detail hereinafter with reference to examples of embodiments. However, it is explicitly noted that the invention is not limited to the described exemplary embodiments.

### Brief Description of the Drawing

Figure 1 shows a power distribution grid during a first stage of fault localization in accordance with an embodiment of the present invention.
Figure 2 shows the power distribution grid during a second stage of fault localization in accordance with an embodiment of the present invention.
Figure 3 shows the power distribution grid during a third stage of fault localization in accordance with an embodiment of the present invention.
Figure 4 illustrates a situation with one inconsistent fault indication during fault localization in accordance with an embodiment of the present invention.
Figure 5 illustrates a situation with two inconsistent fault indications during fault localization in accordance with an embodiment of the present invention.
Figure 6 illustrates a further situation with one inconsistent fault indication during fault localization in accordance with an embodiment of the present invention.

### Detailed Description

The illustration in the drawing is schematic. It is noted that in different figures, similar or identical elements are provided with the same reference numerals or with reference numerals which differ only within the first digit.

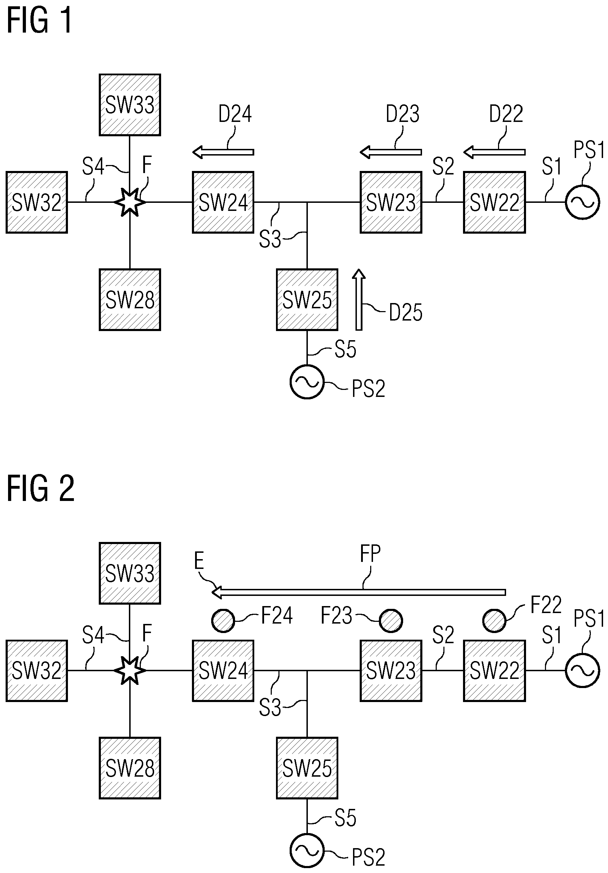

Figure 1, Figure 2 and Figure 3 illustrate different stages of localizing a fault in a power distribution grid using a method according to an embodiment of the present invention. As shown, the power distribution grid comprises a primary power source PS1, e.g. a distribution substation, and a secondary power source PS2, e.g. a distributed generator or prosumer. The power distribution grid further comprises grid segments S1, S2, S3, S4, S5 interconnected by switching devices SW22, SW23, SW24, SW25, SW28, SW32, SW33. The switching devices SW22, SW23, SW24, SW25, SW28, SW32, SW33 are equipped with a protective device (not shown) capable of detecting a fault current and of transmitting a corresponding fault indication, e.g. by means of wired or wireless data communication, to a grid controller (not shown). A fault (in this case an earth fault) is present in grid segment S4 as indicated by star symbol F. It is noted that, although the fault F is indicated in each of Figures 1-3, its location is not known at this stage. Throughout Figures 1-3, closed switching devices are shown as black boxes with white text while opened switching devices are shown as white boxes with black text.

Figure 1 shows a first stage of the fault localization method. At this stage, directional fault indications D22, D23, D24, D25 have been received from the respective protective devices associated with the switching devices SW22, SW23, SW24, SW25 during a time window of predetermined duration (thereby assuring that all relevant fault indications are received before the processing begins). As can be seen, the directional fault indications D22, D23, D24 are so-called forward indications, i.e. they are indicating that the fault current is flowing in a forward (or downstream) direction away from the primary power source PS1. On the other hand, the directional fault indication D25 is a so-called backward indication in the sense that it indicates that the fault current is flowing in a backward (or upstream) direction towards the primary power source PS1. These directional fault indications will now be used to determine the location of the fault F.

Figure 2 shows a second stage of the fault localization method. At this stage, the set of fault indications discussed above is processed to determine a fault path comprising a set of grid segments and corresponding switching devices that form a path for the fault current flowing from the primary power source PS1 towards the fault F. First of all, the backward fault indication D25 is discarded as it cannot form part of the above-mentioned fault path. More specifically, it is determined that there is no downstream path from SW25 towards the fault (the downstream side of SW25, i.e. segment S5, is connected to secondary power source PS2). On the other hand, the other directional fault indications, i.e. D22, D23, D24, are determined to belong to the fault path (as both downstream paths towards the fault and upstream paths towards the primary power source PS1 exist for the corresponding switching devices SW22, SW23, SW24) and these are shown as simple fault indications F22, F23, F24 in Figure 2 with no indications of fault current direction. Thereby, the algorithm will be equally applicable to cases where none or only some of the received fault indications are actually directional fault indications, as well as some cases where one or more of the fault indications are missing (e.g. due to malfunction in the corresponding protective device, extensive transmission delays, etc.). Now, the fault path FP is determined to consist of switching devices SW22, SW23, SW24 and the grid segments S2, S3 interconnecting these switching devices. The fault path FP is represented as an arrow having an end E which is farthest away from the main power source PS1. Then, the next grid segment S4 in front of the fault path FP, i.e. next to the end E of the fault path FP, is selected as the location of the fault F.

The above principle of determining the fault path FP and end E thereof may be implemented using Boolean values and logic as follows.

The fault indications from each protective device are arranged in a first table as follows:

| Protective device | Forward indication | Backward indication |
|---|---|---|
| SW22 | TRUE | FALSE |
| SW23 | TRUE | FALSE |
| SW24 | TRUE | FALSE |
| SW25 | FALSE | TRUE |
| SW28 | FALSE | FALSE |
| SW32 | FALSE | FALSE |
| SW33 | FALSE | FALSE |

Then, logic is applied to the indications of the protective devices and their respective neighboring devices as follows:

| Protective device | Forward indication | Downstream devices | Upstream result | End of fault path |
|---|---|---|---|---|
| SW22 | TRUE | SW23 AND SW24 AND SW25 | FALSE | FALSE |
| SW23 | TRUE | SW24 AND SW25 | FALSE | FALSE |
| SW24 | TRUE | SW33 AND SW32 AND SW28 | TRUE | TRUE |
| SW25 | FALSE | SW24 AND SW23 | FALSE | FALSE |

More specifically, the protective device associated with switching device SW23 has a forward indication equal to TRUE. Its downstream devices (i.e. neighbor devices farther away from the primary power source PS1) are SW24 and SW25. Applying a logic AND operation to the forward indications of these two devices results in an upstream result equal to FALSE. Since the forward indication for SW23 is TRUE and its upstream result is FALSE, also the value in the rightmost column (labeled end of fault path) is FALSE (fault location = forward indication AND upstream result). The same result is found for the protective device associated with switching device SW25.

On the other hand, the protective device associated with switching device SW24 has a forward indication equal to TRUE. Its downstream devices (i.e. neighbor devices farther away from the primary power source PS1) are SW28, SW32 and SW33. Applying a logic AND operation to the forward indications of these three devices results in an upstream result equal to TRUE. Since the forward indication for SW23 is also TRUE, the value in the rightmost column (labeled end of fault path) is TRUE in this case. Thus, SW24 is determined to correspond to the end E of the fault path FP.

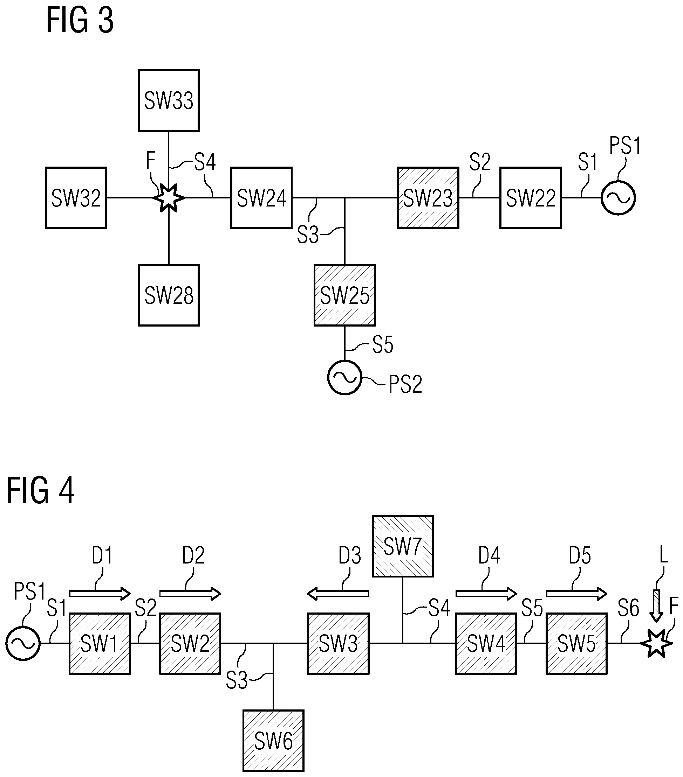

In the third stage of the method according to this embodiment, the fault is isolated by operating corresponding switching devices as shown in Figure 3. More specifically, the switching devices SW24, SW28, SW32, SW33 are all opened in order to isolate the faulty segment S4 from the rest of the power distribution grid. Furthermore, the switching device SW22 closest to the primary power source PS1 may be opened when the fault is detected and then closes again upon successful localization of the fault F to allow the power distribution grid to continue operation as far as possible without the faulty segment S4.

As shown above, the fault is efficiently located and isolated in a fully automated manner without the need for an operator to analyze the fault indications and make a corresponding decision.

According to the present invention, a further improvement of the fault localization method will now be described with reference to Figures 4 to 6, which show a part of a power distribution grid with a slightly different topology than the one discussed above in conjunction with Figures 1 to 3. More specifically, the grid shown in Figures 4 to 6 comprises a single power source PS1, grid segments S1, S2, S3, S4, S5 and S6 interconnected by switching devices SW1, SW2, SW3, SW4, SW5, SW6 and SW7. A fault F is shown at the rightmost end of the grid. The improvement relates to handling of wrong (or missing) fault indications caused by configuration errors, hardware failures, transmission problems, etc. In each of Figures 4 to 6, five directional fault indications D1, D2, D3, D4 and D5 are received.

More specifically, Figure 4 illustrates a situation where five directional fault indications D1, D2, D3, D4 and D5 are received. Analyzing these directional fault indications reveals that the directional fault indication D3 is inconsistent with the other fault indications D1, D2, D4 and D5 as it points towards the power source PS1 while all other fault indications point away from the power source PS1. The number of inconsistent fault indications (in this case one) is compared a predetermined threshold value corresponding to the maximum number of inconsistent fault indications that is allowed while still relying on the automated localization of the fault F as described above. The predetermined threshold value is selected for each grid or sub-grid based on simulations and/or operator experience. In the present case, the threshold value is equal to one. Thus, since the number of inconsistent fault indications does not exceed the threshold value, the determined fault path and in particular the end thereof (switching device SW5) is determined to be reliable and the fault is correctly located in segment S6 as indicated by the arrow L. In other words, the inconsistent fault indication D3 is simply ignored in this case.

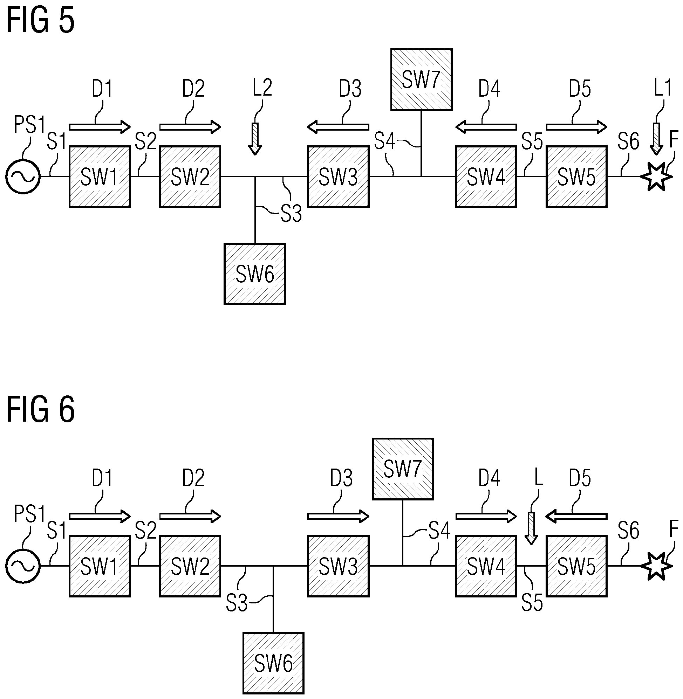

Figure 5 shows a situation where there are two wrong directional fault indications, i.e. D3 and D4. Considering that the threshold value is defined as 1 in this example, the number of inconsistent fault indications exceeds the threshold value and therefore, an error message is generated indicating that it is not possible to automatically locate the fault F in this case. As also shown in Figure 5, ignoring the two inconsistent directional fault indications D3 and D4 would in this case result in an unambiguous localization of the fault, i.e. at segment S6 (which is correct) as indicated by arrow L1 and at segment S3 (which is incorrect) as indicated by arrow L2.

Figure 6 illustrates a further situation where there is only a single wrong fault indication D5 which, however, is located at the end of the fault path. In this case, the last grid segment within the fault path, i.e. in this case grid segment S5, is selected as the fault location as indicated by the arrow L. In other words, the algorithm determines that SW4 constitutes the end of the fault path and then isolates segment S5 in front of the fault path by opening switching devices SW4 and SW5.

It is noted that the term "comprising" does not exclude other elements or steps and the use of the articles "a" or "an" does not exclude a plurality. Also elements described in association with different embodiments may be combined. It is further noted that reference signs in the claims are not to be construed as limiting the scope of the claims.

**List of reference numerals:**

| | | | |
|---|---|---|---|
| PS1 | primary power source | F | fault |
| PS2 | secondary power source | FP | fault path |
| S1 | grid segment | E | end of fault path |
| S2 | grid segment | F22 | fault indication |
| S3 | grid segment | F23 | fault indication |
| S4 | grid segment | F24 | fault indication |
| S5 | grid segment | L | arrow |
| S6 | grid segment | L1 | arrow |
| SW1 | switching device | L2 | arrow |
| SW2 | switching device | | |
| SW3 | switching device | | |
| SW4 | switching device | | |
| SW5 | switching device | | |
| SW6 | switching device | | |
| SW7 | switching device | | |
| SW22 | switching device | | |
| SW23 | switching device | | |
| SW24 | switching device | | |
| SW25 | switching device | | |
| SW28 | switching device | | |
| SW32 | switching device | | |
| SW33 | switching device | | |
| D1 | directional fault indication | | |
| D2 | directional fault indication | | |
| D3 | directional fault indication | | |
| D4 | directional fault indication | | |
| D5 | directional fault indication | | |
| D22 | directional fault indication | | |
| D23 | directional fault indication | | |
| D24 | directional fault indication | | |
| D25 | directional fault indication | | |

## Claims

1. A method of locating a fault in a power distribution grid, the power distribution grid comprising at least one power source (PS1, PS2) and a plurality of grid segments (S1, S2,.., S6) interconnected by switching devices, (SWnn),
each switching device having an associated protective device capable of detecting a fault current and of transmitting a corresponding directional fault indication, the method comprising
receiving a set of directional fault indications (D1, D2, .., D5) from a corresponding set of protective devices,
determining a fault path based on the set of directional fault indications, the fault path comprising a set of grid segments and corresponding switching devices that form a path for the fault current flowing from the power source towards the fault,
selecting the next grid segment in front of the fault path as the location of the fault, and
isolating the fault by operating corresponding switching devices,
**characterized in that**
the method further comprises
identifying inconsistent fault indications in the fault path, and
if the number of inconsistent fault indications is below or equal to a predetermined threshold value, isolating the fault by disconnecting all segments connected to the end of the fault path.

2. The method according to claim 1, further comprising
if the number of inconsistent fault indications is below or equal to the predetermined threshold value and the fault indication corresponding to the end of the fault path is an inconsistent fault indication, selecting the grid segment at the end of the fault path as the fault location.

3. The method according to claim 1 or 2, further comprising
if the number of inconsistent fault indications is below or equal to the predetermined threshold value, disregarding inconsistent fault indications that do not correspond to the end of the fault path.

4. The method according to any of the preceding claims, wherein the set of fault indications comprises at least one directional fault indication pointing to a particular grid segment connected to the corresponding protective device as the direction towards the location of the fault.

5. The method according to the preceding claim, wherein identifying inconsistent fault indications in the fault path comprises identifying directional fault indications which indicate differing or opposite directions towards the location of the fault.

6. The method according to any of the preceding claims, further comprising
if the number of inconsistent fault indications is above the predetermined threshold value, outputting an error message indicating that the location of the fault cannot be determined and/or operating a main switch to disconnect the power distribution grid from the power source.

7. The method according to any of the preceding claims, wherein the set of fault indications is received within a predetermined period of time after receiving a first fault indication.

8. The method according to any of the preceding claims, wherein the power distribution grid is a compensated power distribution grid.

9. The method according to any of the preceding claims, wherein the fault is an earth fault.

10. The method according to any of the preceding claims, wherein the protective devices comprise fault passage indicators, and/or field processors, and/or over-current protective devices.

11. Apparatus for locating a fault in a power distribution grid, the power distribution grid comprising at least one power source and a plurality of grid segments interconnected by switching devices, each switching device having an associated protective device being capable of detecting a fault current and of transmitting a corresponding fault indication, the apparatus comprising a processing unit configured to perform the method according to any of the preceding claims.

12. The apparatus according to the preceding claim, wherein the apparatus is comprised by a protective device, a central device or a cloud computing platform.

13. Computer program comprising computer executable instructions which, when executed by a computer processing unit, are configured to cause the computer to perform the method according to any of claims 1 to 10.

## Patentansprüche

1. Verfahren zur Lokalisierung eines Fehlers in einem Stromverteilungsnetz, wobei das Stromverteilungsnetz mindestens eine Stromquelle (PS1, PS2) und eine Mehrzahl von Netzsegmenten (S1, S2, ..., S6) umfasst, die durch Schaltvorrichtungen (SWnn) miteinander verbunden sind, wobei jede Schaltvorrichtung eine zugehörige Schutzvorrichtung aufweist, die zum Erkennen eines Fehlerstroms und zum Senden einer entsprechenden Fehlerrichtungsanzeige imstande ist, wobei das Verfahren umfasst:
Empfangen eines Satzes von Fehlerrichtungsanzeigen (D1, D2, ..., D5) von einem entsprechenden Satz von Schutzvorrichtungen,
Bestimmen eines Fehlerpfads basierend auf dem Satz von Fehlerrichtungsanzeigen, wobei der Fehlerpfad einen Satz von Netzsegmenten und entsprechenden Schaltvorrichtungen umfasst, die einen Pfad für den Fehlerstrom bilden, der von der Stromquelle zum Fehler fließt,
Auswählen des nächsten Netzsegments vor dem Fehlerpfad als die Fehlerstelle, und
Isolieren des Fehlers durch Auslösen entsprechender Schaltvorrichtungen,
**dadurch gekennzeichnet, dass**
das Verfahren ferner umfasst:
Identifizieren widersprüchlicher Fehleranzeigen im Fehlerpfad und,
falls die Anzahl widersprüchlicher Fehleranzeigen unter oder gleich einem vorgegebenen Schwellenwert ist, Isolieren des Fehlers durch Trennen aller Segmente, die mit dem Ende des Fehlerpfads verbunden sind.

2. Verfahren nach Anspruch 1, ferner umfassend:
Auswählen des Netzsegments am Ende des Fehlerpfads als Fehlerstelle, falls die Anzahl von widersprüchlichen Fehleranzeigen unter oder gleich dem vorgegebenen Schwellenwert ist und die Fehleranzeige, die dem Ende des Fehlerpfads entspricht, eine widersprüchliche Fehleranzeige ist.

3. Verfahren nach Anspruch 1 oder 2, ferner umfassend:
Ignorieren widersprüchlicher Fehleranzeigen, die nicht dem Ende des Fehlerpfads entsprechen, falls die Anzahl widersprüchlicher Fehleranzeigen unter oder gleich dem vorgegebenen Schwellenwert ist.

4. Verfahren nach einem der vorhergehenden Ansprüche, wobei der Satz von Fehleranzeigen mindestens eine Fehlerrichtungsanzeige umfasst, die zu einem spezifischen Netzsegment, das mit der entsprechenden Schutzvorrichtung verbunden ist, als Richtung zur Fehlerstelle zeigt.

5. Verfahren nach dem vorhergehenden Anspruch, wobei das Identifizieren widersprüchlicher Fehleranzeigen im Fehlerpfad ein Identifizieren von Fehlerrichtungsanzeigen umfasst, die unterschiedliche oder entgegengesetzte Richtungen zur Fehlerstelle anzeigen.

6. Verfahren nach einem der vorhergehenden Ansprüche, ferner umfassend:
Ausgeben einer Fehlermeldung, die anzeigt, dass die Fehlerstelle nicht bestimmt werden kann, und/oder Auslösen eines Hauptschalters zum Trennen des Stromverteilungsnetzes von der Stromquelle, falls die Anzahl widersprüchlicher Fehleranzeigen über dem vorgegebenen Schwellenwert ist.

7. Verfahren nach einem der vorhergehenden Ansprüche, wobei der Satz von Fehleranzeigen innerhalb einer vorgegebenen Zeitdauer nach Empfang einer ersten Fehleranzeige empfangen wird.

8. Verfahren nach einem der vorhergehenden Ansprüche, wobei das Stromverteilungsnetz ein Kompensationsstromverteilungsnetz ist.

9. Verfahren nach einem der vorhergehenden Ansprüche, wobei der Fehler ein Erdfehler ist.

10. Verfahren nach einem der vorhergehenden Ansprüche, wobei die Schutzvorrichtungen Fault-Passage-Indikatoren und/oder Feldprozessoren und/oder Überstromschutzvorrichtungen umfassen.

11. Vorrichtung zum Lokalisieren eines Fehlers in einem Stromverteilungsnetz, wobei das Stromverteilungsnetz mindestens eine Stromquelle und eine Mehrzahl von Netzsegmenten umfasst, die durch Schaltvorrichtungen miteinander verbunden sind, wobei jede Schaltvorrichtung eine zugehörige Schutzvorrichtung aufweist, die zum Erkennen eines Fehlerstroms und zum Senden einer entsprechenden Fehleranzeige imstande ist, wobei die Vorrichtung eine Verarbeitungseinheit umfasst, die zum Durchführen des Verfahrens nach einem der vorhergehenden Schritte ausgelegt ist.

12. Vorrichtung nach dem vorhergehenden Anspruch, wobei die Vorrichtung eine Schutzvorrichtung, eine zentrale Vorrichtung oder eine Cloud-Computing-Plattform umfasst.

13. Computerprogramm, umfassend computerausführbare Anweisungen, die so ausgelegt sind, dass sie bei Ausführung durch eine Verarbeitungseinheit eines Computers den Computer zum Durchführen des Verfahrens nach einem der Ansprüche 1 bis 10 veranlassen.

## Revendications

1. Procédé de localisation d'un défaut dans un réseau de distribution d'électricité, le réseau de distribution de l'électricité comprenant au moins une source (PS1, PS2) de courant et une pluralité de segments (S1, S2, ..., S6) de réseau interconnectés par des dispositifs (SWnn) de coupure, chaque dispositif de coupure ayant un dispositif protecteur associé apte à détecter un courant de défaut et à transmettre une indication directionnelle correspondante de défaut, le procédé comprenant
recevoir un ensemble d'indications (D1, D2, ..., D5) directionnelles de défaut d'un ensemble correspondant de dispositifs protecteurs,
déterminer un chemin de défaut, sur la base de l'ensemble d'indications directionnelles de défaut, le chemin de défaut comprenant un ensemble de segments du réseau et de dispositifs de coupure correspondants, qui forment un chemin du courant de défaut allant de la source de courant au défaut,
sélectionner le segment du réseau suivant, en avant du chemin de défaut, comme l'emplacement du défaut, et
isoler le défaut en faisant fonctionner des dispositifs d'interruption correspondants,
**caractérisé en ce que**
le procédé comprend en outre
identifier des indications inconsistantes de défaut dans le chemin de défaut, et
si le nombre d'indications inconsistantes de défaut est inférieur ou égal à une valeur de seuil déterminée à l'avance, isoler le défaut en déconnectant tous les segments connectés au bout du chemin de défaut.

2. Procédé suivant la revendication 1, dans lequel en outre
si le nombre d'indications inconsistantes de défaut est inférieur ou égal à la valeur de seuil déterminée à l'avance et si l'indication de défaut correspondant au bout du chemin de défaut est une indication inconsistante de défaut, on sélectionne le segment du réseau au bout du chemin de défaut comme l'emplacement du défaut.

3. Procédé suivant la revendication 1 ou 2, dans lequel en outre
si le nombre d'indications inconsistantes de défaut est inférieur ou égal à la valeur de seuil déterminée à l'avance, on écarte des indications inconsistantes de défaut, qui ne correspondent pas au bout du chemin de défaut.

4. Procédé suivant l'une quelconque des revendications précédentes, dans lequel l'ensemble d'indications de défaut comprend au moins une indication directionnelle de défaut désignant un segment particulier du réseau connecté au dispositif protecteur correspondant comme la direction allant vers l'emplacement du défaut.

5. Procédé suivant la revendication précédente, dans lequel identifier des indications inconsistantes de défaut dans le chemin de défaut comprend identifier des indications directionnelles de défaut, qui indiquent des directions différentes ou opposées allant vers l'emplacement du défaut.

6. Procédé suivant l'une quelconque des revendications précédentes, dans lequel en outre
si le nombre d'indications inconsistantes de défaut est supérieur à la valeur de seuil déterminée à l'avance, on sort un message d'erreur indiquant que l'emplacement du défaut ne peut pas être déterminé et/ou on fait fonctionner un interrupteur principal pour déconnecter le réseau de distribution d'électricité de la source de courant.

7. Procédé suivant l'une quelconque des revendications précédentes, dans lequel on reçoit l'ensemble d'indications de défaut dans un laps de temps déterminé à l'avance, après avoir reçu une première indication de défaut.

8. Procédé suivant l'une quelconque des revendications précédentes, dans lequel le réseau de distribution d'électricité est un réseau compensé de distribution d'électricité.

9. Procédé suivant l'une quelconque des revendications précédentes, dans lequel le défaut est un défaut à la terre.

10. Procédé suivant l'une quelconque des revendications précédentes, dans lequel les dispositifs protecteurs comprennent des indicateurs de passage de défaut et/ou des processeurs de champ et/ou des dispositifs protecteurs de surintensité de courant.

11. Installation de localisation d'un défaut dans un réseau de distribution d'électricité, le réseau de distribution d'électricité comprenant au moins une source de courant et une pluralité de segments de réseau interconnectés par des dispositifs d'interruption, chaque dispositif d'interruption ayant un dispositif protecteur associé apte à détecter un courant de défaut et à transmettre une indication de défaut correspondante, l'installation comprenant une unité de traitement configurée pour effectuer le procédé suivant l'une quelconque des revendications précédentes.

12. Installation suivant la revendication précédente, dans laquelle l'installation fait partie d'un dispositif protecteur d'un dispositif central ou d'une plateforme de calcul à nuage.

13. Programme d'ordinateur comprenant des instructions, qui peuvent être exécutées par un ordinateur et qui, lorsqu'elles sont exécutées par une unité de traitement de l'ordinateur, sont configurées pour faire que l'ordinateur effectue le procédé suivant l'une quelconque des revendications 1 à 10.
